# EUROPEAN PATENT APPLICATION

(11) **EP 4 653 146 A1**
(43) Date of publication of application: **26.11.2025**
(21) Application number: 25166492.6
(22) Date of filing: 26.03.2025
(51) Int. Cl.: B25F 5/02

(54) **JOB-SITE TOOL**

(30) Priority: 08.04.2024 JP 2024062181
(71) Applicant: Makita Corporation, Anjo-shi Aichi 446-8502 (JP)
(72) Inventor: IWATANI, Takuma, Anjo-shi, 446-8502 (JP); CHIKARAISHI, Makoto, Anjo-shi, 446-8502 (JP)
(74) Representative: Kramer Barske Schmidtchen Patentanwälte PartG mbB

(57) **Abstract**

A job-site tool (1) in one aspect of the present disclosure includes: a display (21); a flexible printed circuit (25); and a control circuit (31). The display (21) is visible from outside and includes at least one surface light emitter (22). The flexible printed circuit (25) includes conductive traces (91 to 97). The at least one surface light emitter (22) is on the flexible printed circuit (25) and is electrically connected to the conductive traces (91 to 97). The control circuit (31) is electrically connected to the display (21) via the conductive traces (91 to 97).

## Description

### CROSS-REFERENCE TO RELATED APPLICATIONS

This application claims the benefit of Japanese Patent Application No. 2024-062181 filed on April 8, 2024 with the Japan Patent Office, the entire disclosure of which is incorporated herein by reference.

### BACKGROUND

The present disclosure relates to a job-site tool equipped with a display.

A power tool disclosed in Japanese Unexamined Patent Application Publication No. 2018-008356 comprises a display including an organic light-emitting (electroluminescent) material. The display receives power from a power-supply circuit of a controller via a lead wire.

### SUMMARY

In the aforementioned tool, it is necessary to connect a lead wire from a display on an outer surface of the tool to a controller inside the tool. However, it is difficult to arrange the lead wire in a limited space inside the tool.

In one aspect of the present disclosure, it is desirable that the controller is easily electrically connected to the display inside the job-site tool.

One aspect of the present disclosure is to provide a job-site tool comprising: a display; a flexible printed circuit; and a control circuit. The display is visible from outside and includes at least one surface light emitter. The flexible printed circuit includes conductive traces. The at least one surface light emitter is on the flexible printed circuit and is electrically connected to the conductive traces. The control circuit is electrically connected to the display via the conductive traces.

In the job-site tool in the present disclosure, the control circuit is electrically connected to the display via the conductive traces included in the flexible printed circuit. The flexible printed circuit is thin, flexible and easily bent while maintaining electrical properties. Accordingly, the controller can be easily electrically connected to the display inside the job-site tool.

Another aspect of the present disclosure is to provide a connection method in a job-site tool, the method comprising:
arranging a display including a surface light emitter on an outer surface of the job-site tool, the surface light emitter being mounted on a flexible printed circuit and electrically connected to conductive traces included in the flexible printed circuit;
arranging the flexible printed circuit inside the job-site tool; and
electrically connecting the surface light emitter to a control circuit provided in the job-site tool via the conductive traces.

Such a method makes it easy to electrically connect the control circuit to the display inside the job-site tool.

### BRIEF DESCRIPTION OF THE DRAWINGS

An example embodiment of the present disclosure will be described hereinafter with reference to the accompanying drawings, in which:
FIG. 1 is a view showing an outer appearance of a job-site tool according to the present embodiment;
FIG. 2 is an electrical diagram of the job-site tool according to the present embodiment;
FIG. 3 is a view showing an upper surface of a display of the job-site tool according to the present embodiment;
FIG. 4 is a vertical cross-sectional view of the display of the job-site tool according to the present embodiment;
FIG. 5 is a view showing a flexible printed circuit and organic light-emitting materials in the display of the job-site tool according to the present embodiment;
FIG. 6 is conductive traces diagram in the display of the job-site tool according to the present embodiment; and
FIG. 7 is a diagram of connections between the display and a controller of the job-site tool according to the present embodiment.

### DETAILED DESCRIPTION OF EXEMPLARY EMBODIMENTS

### [Overview of Embodiments]

One embodiment may provide a job-site tool including at least one of the following:
- Feature 1: a display visible from outside;
- Feature 2: the display includes at least one surface light emitter;
- Feature 3: a flexible printed circuit including conductive traces;
- Feature 4: the at least one surface light emitter is on the flexible printed circuit and electrically connected to the conductive traces; and
- Feature 5: a control circuit that is electrically connected to the display via the conductive traces.

In the job-site tool including at least Features 1 to 5, the control circuit is electrically connected to the display via the conductive traces included in the flexible printed circuit. The flexible printed circuit is thin, flexible and easily bent while maintaining electrical properties. Therefore, it is possible to easily electrically connect the control circuit to the display inside the job-site tool.

In one embodiment, in addition to or in place of at least any one of Features 1 to 5, the job-site tool may include the following:
· Feature 6: the control circuit controls turning on or off of the at least one surface light emitter.

In the job-site tool including at least Features 1 to 6, the control circuit allows a precise control of turning on or off of the at least one surface light emitter.

In one embodiment, in addition to or in place of at least any one of Features 1 to 6, the job-site tool may include the following:
· Feature 7: the at least one surface light emitter is an organic light - emitting (electroluminescent) material.

In the job-site tool including at least Features 1 to 5 and 7, the light source of the display is an organic light-emitting material. This makes it possible to make the display thinner and to provide a wider viewing angle of the display.

In one embodiment, in addition to or in place of at least any one of Features 1 to 7, the job-site tool may include the following:
· Feature 8: the at least one surface light emitter emits light in a single color.

In the job-site tool including at least Features 1 to 5 and 8, a light source of the display is an organic light-emitting material that emits light in a single color. Accordingly, it is unnecessary for the controller to control the color to be emitted. Thus, a process load on the controller can be reduced.

In one embodiment, in addition to or in place of at least any one of Features 1 to 8, the job-site tool may include the following:
· Feature 9: the at least one surface light emitter comprises: a first surface light emitter configured to emit light in a first single color; and a second surface light emitter configured to emit light in a second single color distinct from the first single color.

In the job-site tool including at least Features 1 to 5, 8 and 9, the display comprises a light emitting source that emit light in two or more colors. This allows the display to output two or more colors to thereby display more information.

In one embodiment, in addition to or in place of at least any one of Features 1 to 9, the job-site tool may include the following:
· Feature 10: the flexible printed circuit comprises a first end;
· Feature 11: the flexible printed circuit comprises a second end opposite the first end;
· Feature 12: the conductive traces each includes is an exposed portion configured to be directly or indirectly connected to the control circuit;
· Feature 13: the at least one surface light emitter is arranged on the flexible printed circuit to be closer to the first end than the second end;
· Feature 14: the exposed portion is arranged on the flexible printed circuit to be closer to the second end than the first end.

In the job-site tool including at least Features 1 to 5 and 10 to 14, the at least one surface light emitter is arranged to be closer to the first end than the second end, and the exposed portion is arranged to be closer to the second end than the first end. Such a configuration makes it possible to more easily electrically connect the control circuit to the display inside the job-site tool.

In one embodiment, the job-site tool may include the above-described Features 1 to 4 and 8.

In the job-site tool including at least Features 1 to 4 and 8, the at least one surface light emitter emits light in a single color. In the job-site tool configured as such, the at least one surface light emitter can be turned on without the use of the control circuit. Accordingly, the job-site tool configured as such costs less than a job-site tool comprising the at least one surface light emitter that emits light in multiple colors.

In one embodiment, the method may be provided including at least one of the following:
· Feature 15: arranging the display including the surface light emitter on an outer surface of the job-site tool;
· Feature 16: the surface light emitter is mounted on the flexible printed circuit;
· Feature 17: the surface light emitter is electrically connected to the conductive traces included in the flexible printed circuit;
· Feature 18: arranging the flexible printed circuit inside the job-site tool;
· Feature 19: electrically connecting the surface light emitter to the control circuit in the job-site tool via the conductive traces.

In the job-site tool including at least Features 15 to 19, it is possible to easily electrically connect the controller to the display inside the job-site tool.

In one embodiment, the control circuit may include a microcomputer (or a microcontroller, or a microprocessor), a wired logic, an application-specific integrated circuit (ASIC), an application-specific standard product (ASSP), a programmable logic device (such as a field programmable gate array (FPGA)), a discrete electronic component, and/or a combination of the above.

In one embodiment, examples of the job-site tool may include electric apparatuses for use in job-sites for do-it-yourself carpentry, manufacturing, gardening, construction and so on. Specifically, examples of the job-site tool may include power tools for stone processing, metal processing, and wood processing, and a power-driven tool or a device for preparing an environment of job sites. More specifically, examples of the job-site tool may include an electric blower, an electric hammer, an electric hammer drill, an electric drill, an electric screwdriver, an electric wrench, an electric grinder, an electric circular saw, an electric reciprocating saw, an electric jig saw, an electric cutter, an electric chain saw, an electric planer, an electric nailer (including an electric tacker), an electric hedge trimmer, an electric lawn mower, an electric lawn trimmer, an electric bush cutter, an electric cleaner, an electric sprayer, an electric spreader, an electric dust collector, and a battery-powered wheel barrow. In another embodiment, examples of the job-site tool include an electric apparatus that does not comprise any motor, i.e., a light.

In one embodiment, the above-described Features 1 to 14 may be employed in any combination.

In one embodiment, any of the above-described Features 1 to 14 may be omitted.

### (Embodiments)

### <1. Configuration>

### <1-1. Overall Configuration>

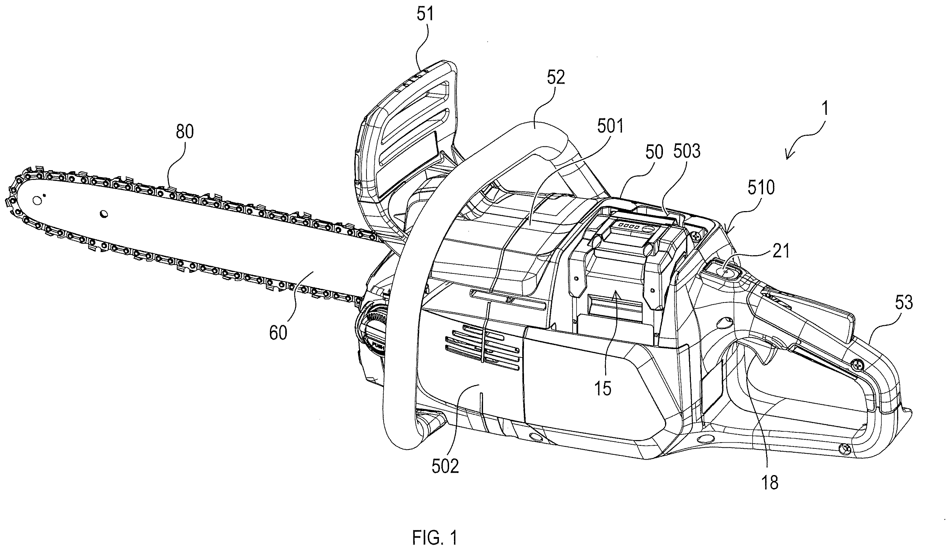

Descriptions will be given of a configuration of a job-site tool 1 according to the present embodiment with reference to FIG. 1. The job-site tool 1 in the present embodiment is a chainsaw, which is a type of power-driven tool.

The job-site tool 1 comprises: a guide bar 60; a saw chain 80; a first grip 52; a hand guard 51; a housing 510; and a display 21. In another embodiment, at least one of the guide bar 60, the first grip 52, and the hand guard 51 may be omitted from the job-site tool 1.

The housing 510 includes: a main body 50; a second grip 53; and a trigger switch 18. In another embodiment, at least one of the second grip 53 and the trigger switch 18 may be omitted from the housing 510.

The main body 50 has a substantially rectangular parallelepiped shape. The guide bar 60 is fixed to the main body 50 to protrude from the main body 50. In the present embodiment, a direction long which the guide bar 60 extends is defined as a front-rear direction, wherein a side toward which the guide bar 60 protrudes is defined as the front. A width direction of the main body 50 is defined as a right-left direction, and a height direction of the main body 50 is defined as an up-down direction.

The saw chain 80 is attached to the guide bar 60. The guide bar 60 supports both a sprocket (not shown), which is provided inside the main body 50, and the saw chain 80 such that it can circulate around the guide bar 60. In response to a later-described motor 30 rotating the sprocket, the saw chain 80 is displaced along an outer circumference of the guide bar 60.

The first grip 52 connects a left surface of the main body 50 to a right surface of the main body 50. There is a space between the first grip 52 and an upper surface of the main body 50. The second grip 53 connects an upper part of a rear surface of the main body 50 to a lower part of the rear surface. There is a space between the second grip 53 and the rear surface of the main body 50. A user using the job-site tool 1 grips the first grip 52 with his/her left hand and grips the second grip 53 with his/her right hand.

The hand guard 51 is in front of the first grip 52 and connected to an emergency stop mechanism of the motor 30. In response to the hand guard 51 being pushed forward by the hand of the user gripping the first grip 52, the motor 30 makes an emergency stop.

The display 21 is at a position where it can be visually observed from outside of the job-site tool 1. Specifically, the display 21 is arranged on an outer surface of the housing 510. More specifically, the display 21 is arranged at a front end of an upper surface of the second grip 53. In another embodiment, the display 21 may be at a position other than the front end of the upper surface of the second grip 53. The display 21 may be on the upper surface, a left-side surface, or a right-side surface of the main body 50. The display 21 may be anywhere on the outer surface of the housing 510.

The display 21 includes a later-described surface light emitter 22 and shows information regarding the job-site tool 1 by turning on, blinking, or turning off the surface light emitter 22. The information regarding the job-site tool 1 includes a state of the job-site tool 1. The state of the job-site tool 1 includes operation modes of the job-site tool 1 and a remaining charge of a later-described battery 26. The operation modes include a normal mode, an eco-mode, and a high-power mode. One of the operation modes is selected by the user using a not shown mode selection switch. The display 21 will be detailed later.

The trigger switch 18 is located on the second grip 53. Specifically, the trigger switch 18 is at a position where the user can pull it with his/her finger of the hand holding the second grip 53. The user manipulates the trigger switch 18 (i) to command the motor 30 to stop or to rotate, and (ii) to command a rotation speed of the motor 30. In response to the user pulling the trigger switch 18, an ON signal is input to a later-described controller 31. In response to the user releasing the trigger switch 18, an OFF signal is input to the controller 31. Additionally, a pulled amount signal proportional to a pulled amount of the trigger switch 18 is input to the controller 31.

The main body 50 comprises: a board housing 501; a motor housing 502; and a battery attachment portion 503.

The board housing 501 is located at a front end and a top end of the main body 50. A later-described control board 71 is housed in the board housing 501. The motor housing 502 is located downward of the board housing 501, i.e., at the front end and a lower end of the main body 50. The motor 30 is housed in the motor housing 502. In another embodiment, the motor housing 502 may be omitted from the main body 50.

The battery attachment portion 503 is located rearward of the board housing 501 and the motor housing 502 and in front of the second grip 53. A later-described battery pack 15 is detachably attached to the battery attachment portion 503. In another embodiment, the battery attachment portion 503 may be omitted from the main body 50.

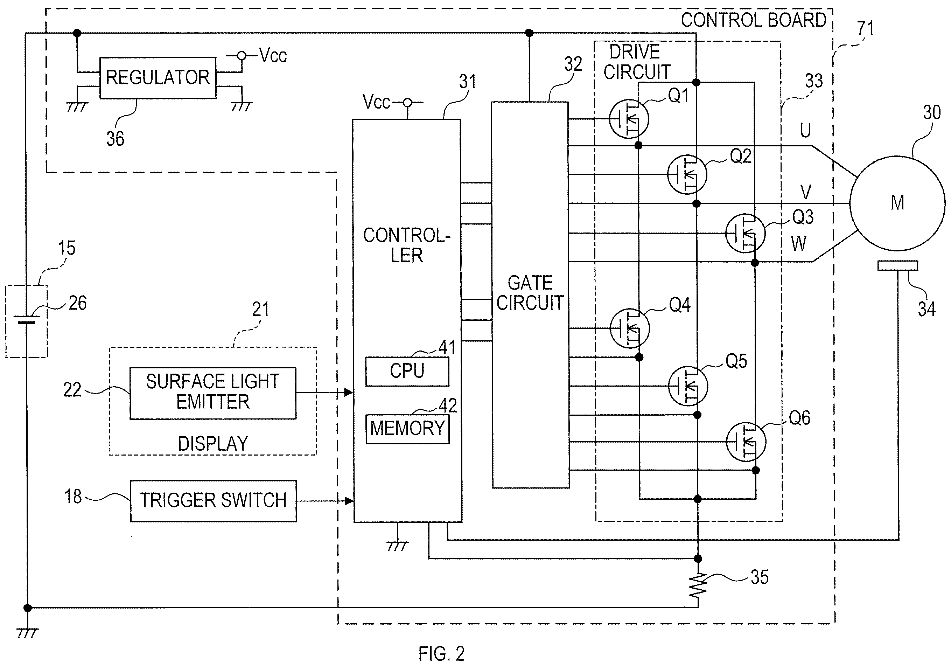

Next, descriptions will be given of an electrical configuration of the job-site tool 1 with reference to FIG. 2. The job-site tool 1 comprises the control board 71. The battery pack 15 is electrically connected to the control board 71. The battery pack 15 includes the battery 26. The battery 26 includes two or more battery cells connected in series. The battery 26 is a rechargeable battery, for example, a lithium ion battery, that can be repeatedly charged and discharged. In response to the trigger switch 18 being pulled, the battery 26 supplies an electric power to the control board 71. In response to the trigger switch 18 being released, the electric power supplied from the battery 26 to the control board 71 is cut off. In another embodiment, the job-site tool 1 may comprise a power supply cord and receive an electric power from an outside AC power source (e.g., a commercial power source) via the power supply cord.

The control board 71 comprises: a regulator 36; the controller 31; a gate circuit 32; a drive circuit 33; and a shunt resistor 35. The display 21, the trigger switch 18, the motor 30, and a rotation sensor 34 are connected to the control board 71. In another embodiment, at least one of the gate circuit 32, the drive circuit 33, and the shunt resistor 35 may be omitted from the control board 71. At least any one of the motor 30 and the rotation sensor 34 may be omitted from the job-site tool 1.

In response to an ON signal being input to the control board 71, the regulator 36 steps down a direct voltage (e.g., 14.4V) supplied from the battery 26 to thereby generate a control voltage Vcc. In response to an OFF signal being input to the control board 71, the regulator 36 stops generating the control voltage Vcc. The control voltage Vcc has a specified direct voltage (e.g., 5V). The regulator 36 supplies the generated control voltage Vcc to the controller 31 or the like.

The motor 30 is a three-phase brushless motor. The motor 30 rotates by receiving the electric power from the battery 26 via the drive circuit 33. In another embodiment, the motor 30 may be a three-phase brushless DC motor, a two-phase brushless DC motor, a four or more-phase brushless DC motor, a brush motor, an AC motor, or a stepping motor.

The rotation sensor 34 includes hall elements disposed corresponding to three phases of the motor 30. The rotation sensor 34 detects a rotational position of a rotor of the motor 30 and outputs a position signal indicating the rotational position to the controller 31.

The drive circuit 33 is a three-phase full-bridge inverter and includes six switching elements. The six switching elements include three high-side switches and three low-side switches. The six switching elements are transistors, specifically field-effect transistors (FETs), and more specifically metal oxide semiconductor field-effect transistors (MOSFETs). The six switching elements may be junction field-effect transistors (JFETs), insulated gate bipolar transistors (IGBTs), bipolar transistors, solid-state relays (SSRs), and thyristors. The drive circuit 33 is connected between positive and negative electrodes of the battery 26 and to a winding of each phase of the motor 30.

The gate circuit 32 is connected to the controller 31 as well as to each of the switching elements of the drive circuit 33. The gate circuit 32 turns on or off each of the switching elements of the drive circuit 33 in accordance with control signals input from the controller 31.

The controller 31 includes a microcomputer, which comprises a CPU 41; a memory 42; an I/O; and the like. The memory 42 includes: a ROM; a RAM; and a rewritable non-volatile memory, such as a flash ROM or an EPPROM. The CPU 41 executes various programs stored in the memory 42, whereby the controller 31 achieves various functions. In the present embodiment, the controller 31 corresponds to one example of the control circuit in Overview of Embodiments.

The controller 31 detects an electric current value based on an electric potential difference between both ends of the shunt resistor 35. The electric current value corresponds to a magnitude of a current flowing from the battery 26. The controller 31 calculates the rotation speed of the motor 30 based on the position signal. The controller 31 generates a control signal based on the input pulled amount signal, the calculated rotation speed, and the detected electric current value so that the motor 30 rotates in one of the operation modes according to a user instruction. Then the controller 31 outputs the generated control signals to the gate circuit 32.

The controller 31 also controls turning on or off of the surface light emitter 22 of the display 21. Specifically, the controller 31 outputs a turn-on signal to the surface light emitter 22 to thereby turn on the surface light emitter 22. Furthermore, the controller 31 outputs a turn-off signal to the surface light emitter 22 to thereby turn off the surface light emitter 22. The controller 31 alternately outputs the turn-on signal and the turn-off signal to the surface light emitter 22 to thereby make the surface light emitter 22 blink. The controller 31 outputs a turn-on signal or a turn-off signal to the surface light emitter 22 depending on the information to be shown by the display 21.

### <1-2. Configuration of Display>

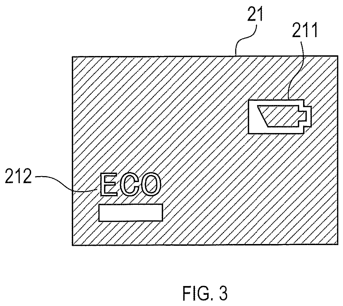

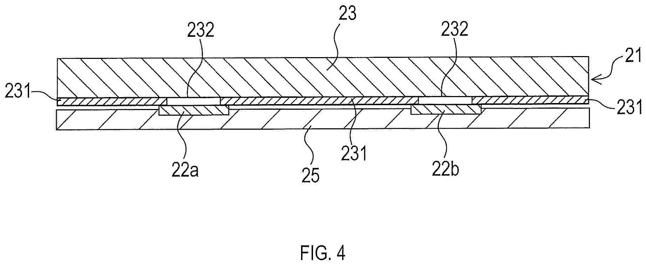

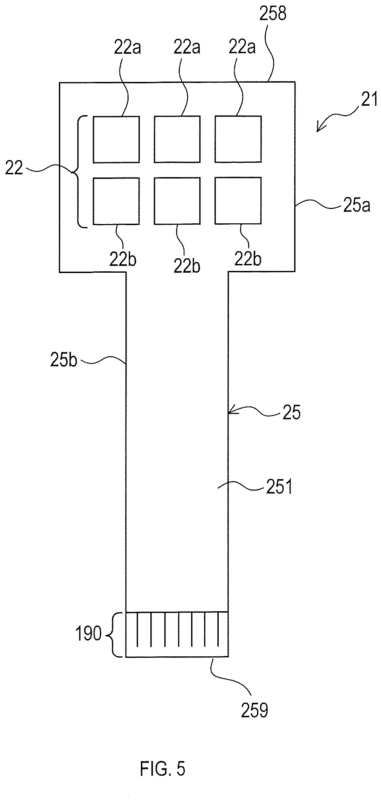

Descriptions will be given of a configuration of the display 21 with reference to FIGS. 3 to 6. As illustrated in FIG. 4, the display 21 is mounted on a flexible printed circuit 25. As illustrated in FIGS. 4 and 5, the display 21 comprises a lens 23 and the at least one surface light emitter 22. The display 21 has a rectangular shape. In another embodiment, the display 21 may have a square, circular, oval, or polygonal shape.

Each of the at least one surface light emitter 22 is a first organic light-emitting (electroluminescent) material 22a or a second organic light-emitting material 22b. The display 21 includes six surface light emitters 22; three of the six surface light emitters 22 include the first organic light-emitting materials 22a, and the remaining three include the second organic light-emitting materials 22b. Each of the first organic light-emitting materials 22a emits light in the first single color. Each of the second organic light-emitting materials 22b emits light in the second single color that is distinct from the first single color. For example, the first single color is red, and the second single color is white. The first organic light-emitting materials 22a and the second organic light-emitting materials 22b emit light from surfaces thereof. In other words, the first organic light-emitting materials 22a and the second organic light-emitting materials 22b emit light with low directivity. The first organic light-emitting materials 22a and the second organic light-emitting materials 22b are organic light-emitting diodes. In another embodiments, the display 21 may include one to five surface light emitters 22 or may include seven or more surface light emitters 22. In another embodiment, the first organic light-emitting materials 22a and the second organic light-emitting materials 22b may be organic light-emitting transistors or organic light-emitting particles.

The lens 23 is colorless, transparent, and rectangular in shape. A lower surface of the lens 23 faces the flexible printed circuit 25 and comprises one or more masked portions 231 and one or more transmitting portions 232. Each of the masked portions 231 is painted in black and interrupts a light from the flexible printed circuit 25 side. Each of the transmitting portions 232 is unpainted and transparent and transmits a light from the flexible printed circuit 25 side to an upper surface of the lens 23. The first organic light-emitting materials 22a and the second organic light-emitting materials 22b are disposed opposite to the transmitting portions 232 on the flexible printed circuit 25. In another embodiment, the lens 23 is not necessarily in a rectangular shape and may be in any shape, such as circle, ellipse, or polygon.

The transmitting portion 232 in formed into a shape corresponding to the information to be shown. Specifically, the transmitting portion 232 is in a form of an icon corresponding to the information to be shown. As illustrated in FIG. 3, each of the transmitting portions 232 includes an icon 211 that indicates a remaining charge of the battery 26, and an icon 212 that indicates the operation mode of the job-site tool 1.

For example, in a case where the remaining charge of the battery 26 is low, the controller 31 turns on one of the first organic light-emitting materials 22a that faces the icon 211 or one of the second organic light-emitting materials 22b that faces the icon 211. In a case where the remaining charge of the battery 26 is high, the controller 31 turns off one of the first organic light-emitting materials 22a that faces the icon 211 or one of the second organic light-emitting materials 22b that faces the icon 211. That is, the display 21 indicates that the battery 26 needs to be charged.

In a case where the operation mode of the job-site tool 1 is the eco-mode, the controller 31 turns on one of the first organic light-emitting materials 22a that faces the icon 212 or one of the second organic light-emitting materials 22b that faces the icon 212. In a case where the operation mode of the job-site tool 1 is a mode other than the eco-mode, the controller 31 turns off one of the first organic light-emitting materials 22a that faces the icon 212 or one of the second organic light-emitting materials 22b that faces the icon 212. That is, the display 21 indicates that the job-site tool 1 in operation in the eco-mode.

In another embodiment, the display 21 may show information other than the remaining charge of the battery 26 and the operating mode of the job-site tool 1 or may show only one piece of information or three or more pieces of information. In another embodiment, the transmitting portion 232 may be formed into letters, symbols, or the like, other than an icon.

Generally, an organic light-emitting material emits light with low directivity and thus widely emits light from its surface. On the other hand, a light-emitting diode (LED) emits light with high directivity and thus emits light in a point-like manner. Thus, it is possible to make a distance between the organic light-emitting material and the display narrower than a distance between the LED and the display. That is to say, in a case where the first organic light-emitting materials 22a and the second organic light-emitting materials 22b are arranged below the lens 23, the first organic light-emitting materials 22a and the second organic light-emitting materials 22b can be disposed closely to the lower surface of the lens 23, as compared to a case where the LED is arranged below the lens 23. Accordingly, in a case where the first organic light-emitting material 22a and the second organic light-emitting material 22b are arranged below the lens 23, it is possible to provide a wider viewing angle of each of the icons 211, 212, as compared to a case where the LED is arranged below the lens 23. Hence, the icons 211, 212 can be viewed from oblique angles.

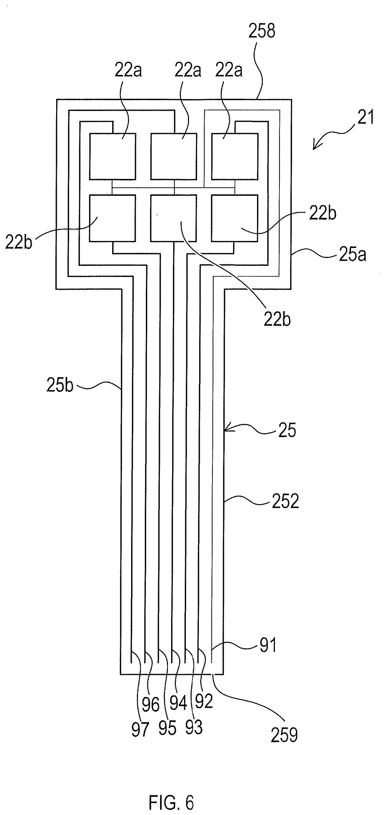

The flexible printed circuit 25 is made from a thin insulating material (e.g., a plastic film, such as a polyimide film). The flexible printed circuit 25 is light, thin, and bendable while maintaining electrical properties. As illustrated in FIGS. 5 and 6, the flexible printed circuit 25 includes: a base film 252 made from an insulating material; a coverlay 251 made from an insulating material; and conductive traces 91 to 97. FIG. 6 shows a state in which the coverlay 251 is omitted from the flexible printed circuit 25.

The flexible printed circuit 25 comprises a first end 258 and a second end 259. The second end 259 is opposite the first end 258 in an extending direction of the flexible printed circuit 25. The flexible printed circuit 25 comprises a first portion 25a including the first end 258 and a second portion 25b including the second end 259. The first portion 25a has a magnitude and shape that correspond to the lens 23. The second portion 25b has a longer shape than the first portion 25a. In another embodiment, the second portion 25b may have a wider shape than the first portion 25a or may have a shorter shape than the first portion 25a.

As illustrated in FIG. 6, the three first organic light-emitting materials 22a and the three second organic light-emitting materials 22b are aligned in a row on the first portion 25a of the base film 252, respectively. Each one of the first organic light-emitting materials 22a and the second organic light-emitting materials 22b has a square shape. In another embodiment, each one of the first organic light-emitting materials 22a and the second organic light-emitting materials 22b does not necessarily have a square shape and may have any shape, such as circle or polygon.

The conductive traces 91 to 97 are arranged in a periphery of the three first organic light-emitting materials 22a and the three second organic light-emitting materials 22b on the first portion 25a of the base film 252. The conductive traces 91 to 97 are electrically connected to the three first organic light-emitting materials 22a and the three second organic light-emitting materials 22b. Each of the conductive traces 91 to 97 is made from a conductor foil, specifically, a copper foil, that is bonded to the base film 252. In another embodiment, each of the conductive traces 91 to 97 may be made from a silver foil or a gold foil.

The conductive traces 91 to 97 are aligned in a row at specified intervals on the second portion 25b of the base film 252. The conductive trace 91 is a positive electrode line shared in common among the three first organic light-emitting materials 22a and the three second organic light-emitting materials 22b. The conductive traces 92 to 97 are negative electrode lines for the three first organic light-emitting materials 22a and the three second organic light-emitting materials 22b, respectively.

On the first portion 25a, the coverlay 251 covers the base film 252 except for upper surfaces of the three first organic light-emitting materials 22a and the three second organic light-emitting materials 22b. On the second portion 25b, the coverlay 251 covers the base film 252 except for an exposed portion 190. The exposed portion 190 is a leading end portion of the conductive traces 91 to 97 and located in a vicinity of the second end 259. Specifically, the conductive traces 91 to 97 are interposed between the base film 252 and the coverlay 251 except for the exposed portion 190. In another embodiment, the coverlay 251 may be omitted from the flexible printed circuit 25.

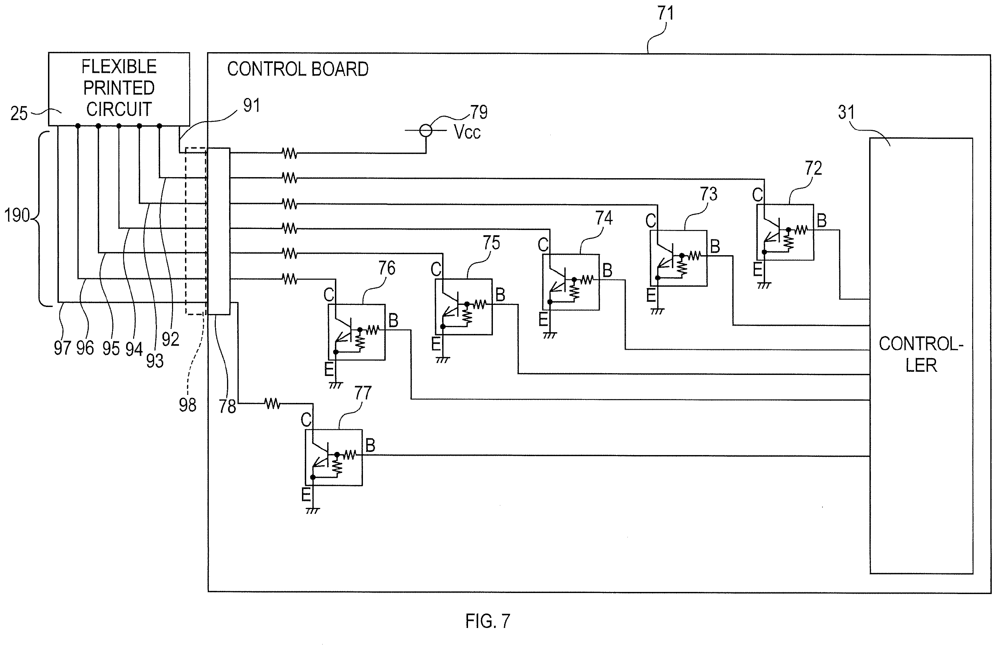

As illustrated in FIG. 7, the control board 71 further comprises a control board connector 78, and switching elements 72, 73, 74, 75, 76, 77. The exposed portion 190 is directly inserted into the control board connector 78 that is attached to the control board 71. The exposed portion 190 may be joined to the control board connector 78 by pressure welding or soldering. Because of the exposed portion 190 directly inserted into the control board connector 78, the connectors on the flexible printed circuit 25 side can be omitted, resulting in a cost reduction. The first organic light-emitting materials 22a and the second organic light-emitting materials 22b are arranged closer to the first end 258 than the second end 259 on the flexible printed circuit 25. The exposed portion 190 is located closer to the second end 259 than the first end 258. In FIG. 7, a part of the exposed portion 190 is inserted into the control board connector 78; however, the exposed portion 190 may be entirely inserted into the control board connector 78.

The controller 31 is electrically connected to the three first organic light-emitting materials 22a and the three second organic light-emitting materials 22b via the control board connector 78, the exposed portion 190, and the conductive traces 91 to 97. As illustrated in FIG. 1, there is the battery attachment portion 503 between the display 21 and the board housing 501. Accordingly, the conductive traces 91 to 97 need to be passed through a limited space behind the battery attachment portion 503 to be laid from the board housing 501 to the display 21.

In a case where a lead wire is used to connect the control board 71 to the display 21, it is difficult to pass the lead wire through a limited space between the display 21 and the control board 71. Accordingly, in a case where a lead wire is used, it is necessary to dispose the display 21 near the control board 71. This lowers the degree of freedom in arranging the display 21 and the control board 71. On the other hand, the flexible printed circuit 25 is thin and highly flexible and can be bent while maintaining electrical properties. Therefore, it is easy to pass the flexible printed circuit 25 through the limited space between the display 21 and the control board 71. Accordingly, with the use of the flexible printed circuit 25, it is possible to dispose the display 21 away from the control board 71. Consequently, it is possible to improve the degree of freedom in arranging the display 21 and the control board 71.

The conductive trace 91 is connected to a power source 79 via the exposed portion 190 and the control board connector 78. The power source 79 supplies the control voltage Vcc, which is generated by the regulator 36, to the conductive trace 91. The conductive traces 92, 93, 94, 95, 96, 97 are respectively connected to the switching elements 72, 73, 74, 75, 76, 77 via the exposed portion 190 and the control board connector 78. The switching elements 72, 73, 74, 75, 76, 77 are connected to the controller 31, and the controller 31 controls turning on and off of the switching elements 72, 73, 74, 75, 76, 77. In response to the controller 31 outputting a turn-on signal, the switching elements 72, 73, 74, 75, 76, 77 become in ON state. In response to the controller 31 outputting a turn-off signal, the switching elements 72, 73, 74, 75, 76, 77 become in OFF state. The switching elements 72, 73, 74, 75, 76, 77 are transistors, for example, bipolar transistors. In another embodiment, the switching elements 72, 73, 74, 75, 76, 77 may be MOSFETs, JFETs, IGBTs, SSRs, or and thyristors.

In a case where the switching element 72 is in an ON state, the conductive traces 91, 92 conduct electricity, whereby the first organic light-emitting material 22a that is electrically connected to the switching element 72 is turned on. In a case where the switching element 72 is in an OFF state, the electric conduction on the conductive trace 92 is interrupted, whereby the first organic light-emitting material 22a that is electrically connected to the switching element 72 is turned off. The first organic light-emitting materials 22a and the second organic light-emitting materials 22b that are electrically connected to the switching elements 73, 74, 75, 76, 77 behave similarly to the first organic light-emitting material 22a.

In another embodiment, as illustrated with a broken line in FIG. 7, the flexible printed circuit 25 may comprise a flexible printed circuit connector 98 attached to the exposed portion 190. The flexible printed circuit connector 98 is configured to be detachable from the control board connector 78. That is to say, the conductive traces 91 to 97 may be electrically connected to the control board connector 78 via the flexible printed circuit connector 98. Because of the flexible printed circuit 25 comprising the flexible printed circuit connector 98, upon a failure of the flexible printed circuit 25, the flexible printed circuit 25 can be separated from the control board 71 by disconnecting the connectors. Consequently, the flexible printed circuit 25 can be easily repaired.

### <2. Effects>

According to the first embodiment as described above, the following effects can be achieved:
(1) The controller 31 is electrically connected to the display 21 via the flexible printed circuit 25, which is thin and flexible. Accordingly, the controller 31 can be easily electrically connected to the display 21 inside the job-site tool 1.
(2) The controller 31 allows a precise control of turning on and off of the first organic light-emitting materials 22a and the second organic light-emitting materials 22b.
(3) The light emitting source of the display 21 is an organic light-emitting material. Thus, it is possible to make the display 21 thinner and to provide a wider viewing angle of the display 21.
(4) Since each of the first organic light-emitting material 22a and the second organic light-emitting material 22b emits light in a single color, it is unnecessary for the controller 31 to control the color emitted by each of the first organic light-emitting material 22a and the second organic light-emitting material 22b. This enables to reduce the process load on the controller 31.
(5) Since the color of the light emitted by the first organic light-emitting material 22a is distinct from the color of the light emitted by the second organic light-emitting material 22b, the display 21 can output two or more colors. Consequently, the display 21 is capable of displaying more information.
(6) The first organic light-emitting material 22a and the second organic light-emitting material 22b are arranged close to the first end 258 of the flexible printed circuit 25, and the exposed portion 190 is arranged close to the second end 259 of the flexible printed circuit 25. Accordingly, it is possible to more easily electrically connect the controller 31 to the display 21 inside the job-site tool.

### (Other Embodiments)

Although one embodiment to implement the present disclosure has been described above, the present disclosure is not limited to the above-described embodiment but may be implemented in various modified forms.
(a) Although the at least one surface light emitter 22 includes two or more first organic light-emitting materials 22a and two or more second organic light-emitting materials 22b in the above-described embodiment, the present disclosure is not limited to the above-described embodiment. The at least one surface light emitter 22 may include one or more first organic light-emitting materials 22a only or one or more second organic light-emitting materials 22b only. In other words, the at least one surface light emitter 22 may emit light in only a single color. Furthermore, the at least one surface light emitter 22 may include one or more third organic light-emitting materials, in addition to one or more first organic light-emitting materials 22a and one or more second organic light-emitting materials 22b. Each of the third organic light-emitting materials emits light in a single color that is distinct from the first single color or the second single color. Specifically, the at least one surface light emitter 22 may emit light in three or more single colors.
(b) In the above-described embodiment, the controller 31 controls turning on and off of the first organic light-emitting material 22a and the second organic light-emitting material 22b; however, the controller 31 may not control turning on and off of the first organic light-emitting material 22a and/or the second organic light-emitting material 22b. The first organic light-emitting material 22a and/or the second organic light-emitting material 22b may be directly connected to the regulator 36. In a case where the power source of the job-site tool 1 is on, the first organic light-emitting material 22a and/or the second organic light-emitting material 22b may be turned on upon reception of an electric power from the regulator 36. The first organic light-emitting material 22a and/or the second organic light-emitting material 22b may be turned off in response to the power source of the job-site tool 1 becoming off. In this case, the first organic light-emitting material 22a and/or the second organic light-emitting material 22b may not be electrically connected to the controller 31.
(c) Each of the first organic light-emitting material 22a and/or the second organic light-emitting material 22b emits light in a single color in the above-described embodiment but may emit light in multiple colors. In a case where each of the first organic light-emitting material 22a and/or the second organic light-emitting material 22b emits light in multiple colors, the controller 31 may control the light emitted by each of the organic light-emitting materials.
(d) In the above-described embodiment, the three first organic light-emitting materials 22a and the three second organic light-emitting materials 22b are connected to the positive electrode line shared in common and to the individual negative electrode lines. However, the three first organic light-emitting materials 22a and the three second organic light-emitting materials 22b may be connected to individual positive electrode lines and to a negative electrode line shared in common.
(e) Although the exposed portion 190 is connected to the control board connector 78 directly or via the flexible printed circuit connector 98 in the above-described embodiment, the present disclosure is not limited to the above-described embodiment. The exposed portion 190 may be connected to a lead wire that is then attached to the flexible printed circuit connector 98. The conductive traces 91 to 97 may be connected to the control board connector 78 via the lead wire and the flexible printed circuit connector 98. For example, in a case where the job-site tool 1 is a brush cutter, the display 21 is provided to a handle positioned in the middle of the brush cutter's rod, and the control board 71 is provided inside a case provided at a lower end of the rod. In this case, the flexible printed circuit 25 can be arranged inside the handle, which has a relatively limited space and a relatively short length, and the lead wire can be arranged inside the rod, which has a relatively large space and a relatively long length.
(f) Although the surface light emitter 22 is an organic light-emitting material in the above-described embodiment, the surface light emitter 22 may be an inorganic light-emitting material. The surface light emitter 22 may be an LED including a dispersion member or a light guiding member to disperse or guide light to thereby perform surface light emission. The dispersion member includes a dispersion plate and a dispersion film. The light guiding member includes a light guiding plate.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A job-site tool (1) comprising:
a display (21) visible from outside and including at least one surface light emitter (22);
a flexible printed circuit (25) including conductive traces (91 to 97), the flexible printed circuit (25) having mounted thereon the at least one surface light emitter (22), the at least one surface light emitter electrically connected to the conductive traces (91 to 97); and
a control circuit (31) electrically connected to the display (21) via the conductive traces (91 to 97).

2. The job-site tool (1) according to claim 1,
wherein the control circuit (31) is configured to control turning on or off of the at least one surface light emitter (22).

3. The job-site tool (1) according to claim 1 or 2,
wherein the at least one surface light emitter (22) includes an organic light-emitting material (22a; 22b).

4. The job-site tool (1) according to any one of claims 1 to 3,
wherein the at least one surface light emitter (22) is configured to emit light in a single color.

5. The job-site tool (1) according to claim 4,
wherein the at least one surface light emitter (22) includes:
a first surface light emitter (22a) configured to emit light in a first single color; and
a second surface light emitter (22b) configured to emit light in a second single color distinct from the first single color.

6. The job-site tool (1) according to any one of claims 1 to 5,
wherein the flexible printed circuit (25) includes:
a first end (258);
and a second end (259) opposite the first end (258),
wherein the conductive traces (91 to 97) each includes an exposed portion (190) configured to be directly or indirectly connected to the control circuit (31),
wherein the at least one surface light emitter (22) is arranged on the flexible printed circuit (25) to be closer to the first end (258) than the second end (259), and
wherein the exposed portion (190) is arranged on the flexible printed circuit (25) to be closer to the second end (259) than the first end (258).

7. A connection method in a job-site tool (1), the method comprising:
arranging a display (21) including a surface light emitter (22) on an outer surface (510) of the job-site tool (1), the surface light emitter (22) being mounted on a flexible printed circuit (25) and electrically connected to conductive traces (91 to 97) included in the flexible printed circuit (25);
arranging the flexible printed circuit (25) inside the job-site tool (1); and
electrically connecting the surface light emitter (22) to a control circuit (31) provided in the job-site tool (1) via the conductive traces (91 to 97).
